# NEW EUROPEAN PATENT SPECIFICATION

(11) **EP 1 217 089 B2**
(45) Date of publication and mention of the opposition decision: **08.05.2013**
(45) Mention of the grant of the patent: 09.03.2005
(21) Application number: 01310695.0
(22) Date of filing: 20.12.2001
(51) Int. Cl.: C23C 4/02, C23C 14/02

(54) **Enhanced surface preparation process for application of ceramic coatings**
Verbesserte Vorbereitung einer Oberfläche zum Auftragen von keramischen Beschichtungen
Préparation améliorée d'une surface pour l'application de revêtements céramiques

(30) Priority: 22.12.2000 US 747713
(43) Date of publication of application: 26.06.2002
(73) Proprietor: United Technologies Corporation, Hartford, CT 06101 (US)
(72) Inventor: Burns, Steven M., West Hartford, CT 06107 (US); Marszal, Dean N., Southington, CT 06489 (US)
(74) Representative: Hall, Matthew Benjamin

(56) References cited:
- WO-A-01/15866
- US-A- 4 287 740
- US-A- 4 514 469

## Description

This invention relates to the preparation of metallic or intermetallic surfaces, particularly bond coat surfaces for the subsequent application of ceramic coatings, particularly ceramic thermal barrier coatings for use at elevated temperatures.

WO 0115866 discloses a method for the surface treatment having a curved component surface comprising removing material from the component surface.

U.S. patent 4,321,310 discusses polishing bond coats prior to applying ceramic thermal barrier coatings.

The present invention provides methods as set out in claims 1 and 10.

Other steps including diffusion heat treatments, cleaning heat treatments, and mechanical processing such as peening may also be used in conjunction with the progressively decreasing abrasion step.

Certain preferred embodiments of the present invention will now be described in greater detail by way of example only and with reference to the accompanying drawings in which:
Figures 1 through 5 are flow charts which illustrate various embodiments of the invention;
Figure 6 is a photomicrograph of cross section of a cathodic arc deposited bond coat at 400X;
Figure 7 is a photomicrograph of cross section of a cathodic arc deposited bond coat at 400X after ceramic pressure peening; and
Figure 8 is a photomicrograph of cross section of a cathodic arc deposited bond coat at 400X after ceramic pressure peening and progressively reduced grit blasting.

The present invention relates to methods for preparing metallic or intermetallic surfaces, particularly bond coat surfaces, to receive a subsequent ceramic coating. The surface preparation process substantially increases the adherence of the ceramic coating to the surface and increases the life of the coating under severe conditions of elevated temperature such as those encountered in gas turbine engines.

Ceramic coating may be applied directly to certain metallic surfaces which form a dense adherent alumina scale, see for example U.S. patent 5,262,245. Usually however, an intermediate bond coat is applied to the surface prior to the application of the ceramic coating.

The most common type of bond coat known in the art as an MCrAlY bond coat, where M is selected from the group consisting of iron, nickel, cobalt and mixtures of nickel and cobalt. See, for example, U.S. patent 3,928,026.

MCrAlY type bond coats may be applied using electron beam vapor deposition (EBPVD), cathodic arc deposition, plasma spray deposition including low pressure plasma spraying (LPPS), sputtering, and electrodeposition. While the invention process was specifically developed for use with bond coat supplied by cathodic arc deposition, it is not so limited.

An important aspect of the present invention is the use of an abrasive treatment, having certain specific characteristics, to remove a portion of the surface which is to receive the ceramic coating.

It is often found, particularly with respect to some types of bond coat deposition processes such as cathodic arc, that the surface of the as-applied bond coat has defects, such as pores, fissures, etc. and is rough and irregular.

According to the present invention, a portion of the surface which is to receive the ceramic coating is removed by abrasion to a depth which removes any imperfect outer portion of the surface layer which may be present. Generally speaking, a total of up to about 1.0 mil (.0010 in.) may be removed. Most commonly, for cathodic arc deposited coatings, between about .0005 and .0010 in. (.5-1.0 mil) will be removed.

We have found that using a relatively aggressive initial abrasive treatment followed by at least one subsequent, less aggressive, abrasive treatment results in a substantially increased life for a subsequently applied ceramic coating. We define the degree of aggressiveness of an abrasive surface treatment in terms of the rate of surface removal, the unit thickness removed per unit time. More aggressive abrasive treatments remove more material in a given period of time.

Thus, for example, we have used grit blasting in which alumina particles are propelled by a fluid (such as compressed air) against the surface to be abraded. The aggressiveness of the abrasive process can be controlled by controlling velocity and/or pressure of the fluid which contains and propels the abrasive media and/or the nozzle to substrate distance. In general, higher fluid pressures/velocities produce a more aggressive abrasive treatment than do lower fluid pressures/velocities as do reduced nozzle-substrate distances, assuming that other process details remain constant.

While it is, as noted above, necessary to use at least two abrasive treatments of decreasing intensity, it is preferred to use at least three abrasive treatments of decreasing intensity.

It will also be appreciated that the same result can be achieved using a single abrasive treatment step in which the degree of aggressiveness of the abrasive process is varied and decreases from the start of the step to the finish of the step. The nature of the decrease may be stepwise or continuous, or combinations thereof. Thus, for example, instead of using two or three separate grit blasting steps using progressively lower air pressure, it is possible to use a single grit blasting operation in which the air pressure decreases from the start of the step to the end of the step. It is also possible to combine constant abrasive aggressiveness with one or more steps of degreasing abrasive aggressiveness.

Oxide ceramic abrasives are preferred because any residual embedded particles will be relatively stable and innocuous. We prefer to use alumina as an abrasive material but other abrasives, including zirconia and silica, may be used especially for the earlier abrasive treatment steps. Use of alumina for the final, least aggressive, abrasion step is highly preferred.

It has been found that using a decreasing intensity abrasive process or processes produces a relatively smoother surface finish than would otherwise be obtained if an abrasive step of constant intensity were utilized.

The skilled artisan will appreciate that several factors affect the intensity or rate of abrasion of a given surface. These include abrasive particle size, abrasive particle composition, abrasive particle velocity, the angle at which the particles strike the surface, and the number of particles interacting with a unit surface area in a unit time and the nozzle to substrate distance.

It is well within the skill of the art to select and vary these factors to arrive at a suitable combination to accomplish the present invention.

A variety of abrasion processes are known in the art, including:
1. Grit blasting wherein abrasive particles are propelled at a surface
   a. by a flowing gas stream
   b. by a flowing liquid stream
   c. by centrifugal force imparted by a rotating disc or wheel.
2. Vibratory finishing wherein the parts to be abraded are placed in a container along with abrasive media (often with a liquid added) and the container is vibrated to cause the abrasive media to abrade the parts.
3. Barrel finishing, similar to vibratory finishing except that the container is closed and rotated about a generally horizontal axis to cause motion (tumbling) and abrasion.
4. Centrifugal disc finishing in which a rotating disc spins abrasive media and parts in a stationary chamber.
5. Centrifugal barrel finishing which uses closed chambers, containing parts and abrasive media, which are mounted on a rotating turret. The closed chambers counter rotate.
6. Spindle finishing in which parts are mounted on movable spindles which are then immersed in a moving bed of abrasive media.
7. Drag finishing in which parts are mounted on rotating fixtures which are immersed in and dragged through a bed of abrasive media.

All of these techniques can potentially be used in connection with the present invention, although some may remove material at such a high rate as to be impractical.

In practical applications, contamination of hollow parts, such as cooled turbine airfoils, with abraded debris/sludge can be a problem. This suggests that liquid media processes may be generally less suitable.

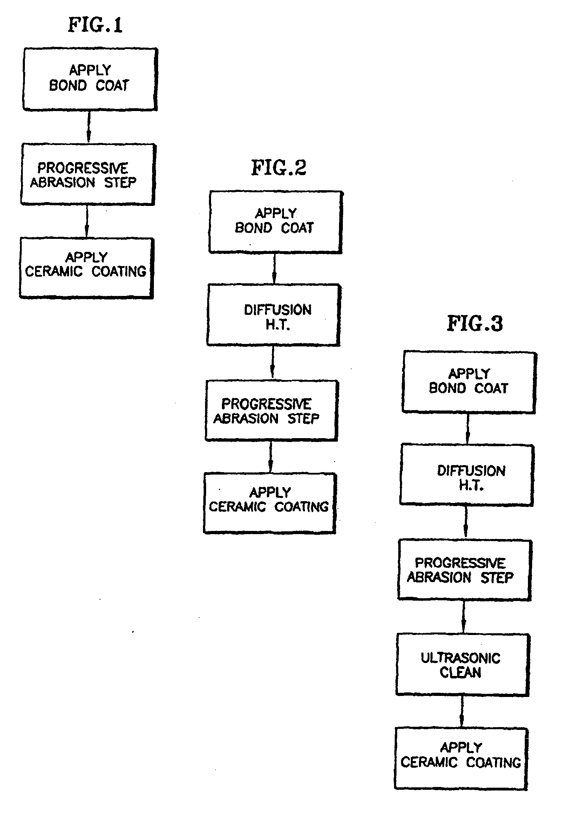

Figure 2 shows further development of the present invention in which a diffusion heat treat step is performed between the bond coating application step and the progressive abrasion step. It is known in the prior art to perform diffusion heat treat steps in connection with bond coats in order to improve their adherence to the substrate by promoting interdiffusion between the bond coat and the substrate. Such a diffusion heat treatment step appears to be highly desired in the case of cathodic arc-applied bond coats which, because they are deposited at relatively low temperatures and have relatively low adherence in the as-applied state. A diffusion heat treatment is not required if the ceramic coating is to be applied directly to a substrate without a bond coat.

A typical diffusion heat treatment step is performed at a temperature of 1080°C (1975°F) for a period of about four hours. Temperatures between about 980°C (1800°F) and about 1150°C (2100°F) may be employed for times ranging from about one-half hour up to about 20 hours.

Figure 3 shows another step which is added to the step shown in Figure 2 which comprises an ultrasonic cleaning step performed after the progressive abrasion step. It has been found that the abrasive operation produces fine particles of the abrasive material and the abraded material which are difficult to remove from the surface using cleaning methods such as air blasting. Ultrasonic cleaning using an aqueous solution has been used. Pure water has been used but it is possible to employ wetting agents, which may enhance the cleaning effectiveness, but care must be taken to ensure that any ultrasonic cleaning solution residue does not interfere with adherence of the ceramic layer to be deposited.

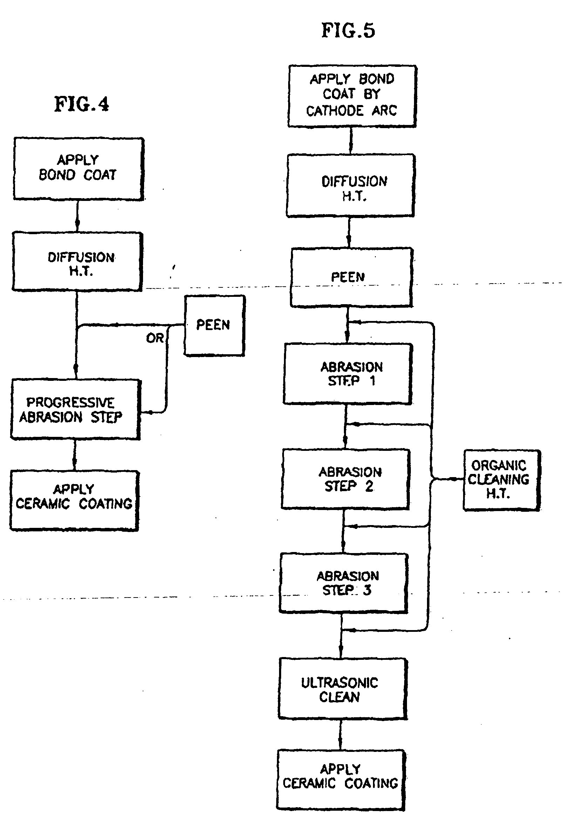

Figure 4 shows another step added to the steps in Figure 3 which consists of a peening operation which is performed either immediately after the diffusion heat treatment and before the progressive abrasion step, or alternately after the first abrasion step. Peening is used to densify bond coats by closing internal voids and other defects. We prefer to use ceramic pressure peening. Ceramic pressure peening is similar in some ways to grit blasting. A pressure fed type grit blasting machine propels ceramic particles at the surface to be peened. Smooth rounded ceramic particles are used and minimal surface removal occurs. We have used a commercially available material known as Zirshot, a product of SEPR of Paris, France, a unit of the St. Gobain Corporation, the media is available from SEPR of Mountainside, N.J. We use round particles having an average diameter of 0.046 in. Zirshot is an alloy of zirconia and silica.

We prefer to peen to an intensity as measured by the Almen test strip method, of from about 13-17 N, more specifically 14-16 N. Ceramic pressure peening is preferred because it has been found not to damage delicate parts to the extent that some other peening methods do, however generally speaking any peening method may be used which provides the required Almen intensity without damaging the part or contaminating the part surface.

Figure 5 shows another step added to the step shown in Figure 4, a heat treatment performed after any peening operation but prior to ultrasonic cleaning. This heat treatment is used to remove any organic residue or contamination such as that left by fingerprints or oil vapors in the ambient atmosphere. A heat treatment at about 705°C (1300°F) for about one-half hour, but temperatures between about 540°C (1000°F) and 815°C (1500°F) for times between about one-half hour and 4 hours are appropriate.

We prefer that all part handling after the organic heat treatment step is performed by operators wearing fabric or plastic gloves to eliminate the possibility of subsequent organic contamination.

After the surface is prepared, the ceramic coating can be applied by EBPVD, sputtering, or thermal spray techniques.

### Example 1

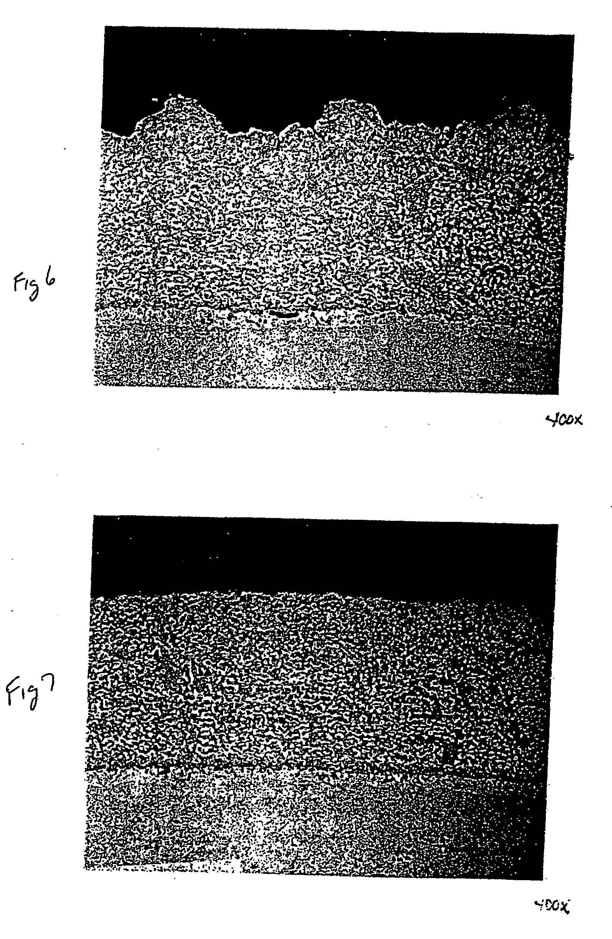

Twelve gas turbine blades having a nominal composition of (by wt.) 5% Cr, 10% Co, 2% Mo, 6% W, 3.1% Re, 5.6% Al, 9% Ta, .1% Hf, bal essentially Ni, were coated with an MCrAlY having a nominal composition of (by wt.) 22% Co, 17% Cr, 12.5% Al, 0.25% Hf, 0.4% Si, 0.6% Y, bal essentially Ni, using a cathodic arc coating process. The nominal coating thickness was 4 mil. Figure 6 shows a cross sectional photo micrograph (at 400X) of the as applied coating. The rough surface is readily visible, and had a measured roughness of about 195 microinches R.A..

The as coated blades were treated by ceramic pressure peening, using ceramic beads Zirshot, 0.046 in dia., applied using a pressure feed peening apparatus operated at a constant air pressure of 30 psi for 5 minutes. Figure 7 is a photomicrograph showing the surface after ceramic pressure peening. A significant improvement in surface condition is visible, the measured surface roughness after peening was about 135 microinches R.A.

The pressure peened parts then had a columnar ceramic coating applied by EBPVD. The ceramic coating composition was zirconia stabilized with 7 wt % ytttria. The ceramic coating thickness was about 5 mil.

The ceramic coated parts were tested in a cyclic thermal (at 1150°C (2100°F)) test simulating engine operation.

The average time to coating failure (defined as about 50% spallation of the ceramic coating) was determined.

### Example 2

Six turbine blades of the same composition as those described in Example 1. The six blades were coated with the same MCrAlY composition to the same thickness using the same cathodic apparatus.

Ceramic pressure peening was performed according to the present invention using the same pressure peening apparatus and peening media as that used in Example 1.

The six parts were then grit blasted as follows: two minutes at 75 psi, 2 minutes at 55 psi and 1 minute at 35 psi using 240 mesh aluminum oxide grit. After this progressively reduced aggressiveness processing, the measured surface roughness was 69 microinches R.A..

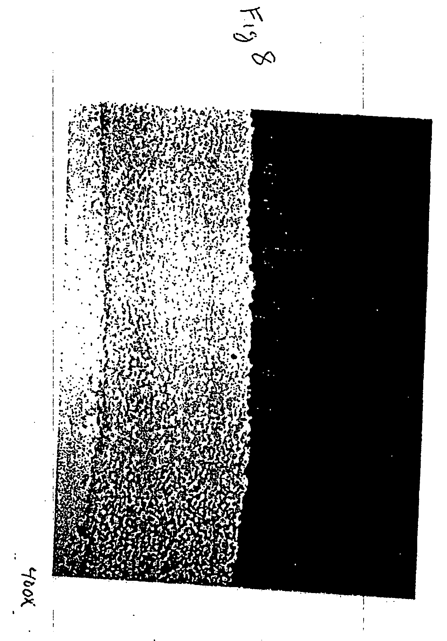

After grit blasting at progressively reduced intensity, the parts were coated with the same EBPVD applied ceramic coating as used in Example 1 to the same thickness. Figure 8 shows a cross section with the ceramic coating applied.

The six parts were tested using the same 1150°C (2100°F) cyclic test as used in Example 1.

The sample processed according to the present invention displayed an 87% improvement in cyclic life.

## Claims

1. A method for preparing a turbine blade to receive a ceramic coating, wherein the surface of the turbine blade has a bond coat and the method comprises:
removing material from the bond coat surface at a progressively decreasing rate by employing an abrasion process of decreasing intensity;
wherein the abrasion process comprises grit blasting, and the intensity is controlled by controlling the velocity and/or pressure of the fluid which contains and propels the abrasive media, and/or by controlling the nozzle to substrate distance.

2. A method as in Claim 1 in which the material is removed by abrasion and which includes at least two abrasion steps and wherein the first step removes material at a rate which is at least twice the rate of the last abrasion step.

3. A method as in Claim 2 which includes at least three abrasion steps of progressively reducing intensity.

4. A method as claimed in any preceding claim wherein the abrasion is caused by oxide ceramic abrasive particles.

5. A method as claimed in any preceding claim wherein the bond coat is an MCrAlY coating.

6. A method as in Claim 5 wherein the bond coat has been applied by a method selected from the group consisting of EBPVD, cathodic arc deposition, plasma spray deposition, electroplating, and sputtering.

7. A method as claimed in any preceding claim in which a diffusion heat treatment is performed prior to the progressively decreasing rate material removal process step.

8. A method as claimed in any preceding claim in which an ultrasonic cleaning step is performed subsequent to the progressively decreasing rate material removal process step.

9. A method as in Claim 7 in which a surface peening operation is performed subsequent to the diffusion heat treatment step.

10. A method for applying a ceramic thermal barrier coating to a metallic substrate including the steps of:
a) applying an MCrAlY bond coat to the substrate using a cathodic arc deposition process
b) diffusion heat treating the coated substrate
c) peening the diffusion heat treated coaled substrate
d) abrasively removing material from the bond coat at a progressively reducing rate
e) ultrasonically cleaning the abrasively treated bond coat
f) applying a ceramic coating.

11. A method as in Claim 10 wherein the abrasive removal process is performed using oxide ceramic abrasive materials.

12. A method as in Claim 10 or 11 wherein the abrasive removal process occurs at an initial rate which is at least twice as great as the rate of removal at the end of the abrasive removal process.

13. A method as in Claim 10, 11 or 12, wherein the peening is performed to an intensity of from 13-17 N on the Almen scale.

14. A method as in any of Claims 10 to 13 wherein the diffusion heat treatment is performed at a temperature of from about 980°C (1800°F) to about 1150°C (2100°F) for a time of from about .5 to about 10 hours.

## Patentansprüche

1. Verfahren zum Aufbereiten einer Turbinen-Laufschaufel zum Aufnehmen einer keramischen Beschichtung, wobei die Oberfläche der Turbinen-Laufschaufel eine Bindungsschicht hat, und wobei das Verfahren aufweist:
Entfernen von Material von der Bindungsschicht-Oberfläche mit einer fortschreitend abnehmenden Rate, durch Verwendung eines Abreibeverfahrens mit abnehmender Intensität;
wobei das Abreibeverfahren Strahlgutstrahlen aufweist, und wobei die Intensität durch Regulieren der Geschwindigkeit und/oder des Drucks des Fluids, welches das abreibende Medium enthält und antreibt, und/oder durch Regulieren der Entfernung von Düse zu Substrat reguliert wird.

2. Verfahren nach Anspruch 1, bei welchem das Material durch Abreiben entfernt wird und welches mindestens zwei Abreibeschritte aufweist und bei welchem der erste Schritt Material mit einer Rate entfernt, welche mindestens das Doppelte der Rate des letzten Abreibeschritts ist.

3. Verfahren nach Anspruch 2, welches mindestens drei Abreibeschritte mit fortschreitend abnehmender Intensität aufweist.

4. Verfahren nach einem der vorangehenden Ansprüche, bei welchem das Abreiben bewirkt wird durch Oxidkeramik-Abreibepartikel.

5. Verfahren nach einem der vorangehenden Ansprüche, bei welchem die Bindungsschicht eine MCrAIY-Beschichtung ist.

6. Verfahren nach Anspruch 5, bei welchem die Bindungsschicht aufgebracht wurde durch ein Verfahren, welches gewählt Ist aus der Gruppe, die aus EBPVD, Kathoden-Lichtbogenabschelden, Plasmaspray-Abscheiden, Elektroplattlerung und Sputtern besteht,

7. Verfahren nach einem der vorangehenden Ansprüche, bei welchem eine Diffusionswärmebehandlung durchgeführt wird vor dem Schritt der Entfernung von Material mit fortschreitend abnehmender Rate.

8. Verfahren nach einem der vorangehenden Ansprüche, bei welchem ein Ultraschall-Reinigungsschritt durchgeführt wird nach dem Schritt des Entfernens von Material mit fortschreitend abnehmender Rate.

9. Verfahren nach Anspruch 7, bei welchem ein Oberflächen-Peening-Arbeitsschritt nach dem Diffusionswärmebehandlungsschritt durchgeführt wird.

10. Verfahren zum Aufbringen einer keramischen Wärmebarrierenbeschichtung auf ein metallisches Substrat, aufweisend die folgenden Schritte:
a) Aufbringen einer MCrAIY-Bindungsschicht auf das Substrat unter Verwendung eines Kathoden-Lichtbogenablagerungsprozesses
b) Diffusionswärmebehandlung des beschichteten Substrats
c) Peening des diffusionswärmebehandelten, beschichteten Substrats
d) abreibendes Entfernen von Material von der Bindungsschicht mit einer fortschreitend abnehmenden Rate
e) Ultraschall-Relnigen der Abreibe-behandelten Bindungsschicht
f) Aufbringen einer keramischen Schicht.

11. Verfahren nach Anspruch 10, bei welchem der Schritt des abreibenden Entfernens durchgeführt wird unter Verwendung von Oxldkeramik-Abreibematerialien.

12. Verfahren nach Anspruch 10 oder 11, bei welchem der Schritt des abreibenden Entfernens bei einer anfänglichen Rate stattfindet, weiche mindestens zweimal so groß ist wie die Entfernungsrate am Ende des Abreibe-Entfernungsschritts.

13. Verfahren nach Anspruch 10, 11 oder 12, bei welchem das Peening durchgeführt wird mit einer Intensität von 13 bis 17 N auf der Almen-Skala.

14. Verfahren nach einem der Ansprüche 10 bis 13, bei welchen die Diffusionswärmebehandlung durchgeführt wird bei einer Temperatur von ca. 980°C (1800°F) bis ca. 1150°C (2100°F) für eine Zeit von ca. 0,5 bis ca. 10 h.

## Revendications

1. Procédé de préparation d'une aube de turbine pour la réception d'un revêtement céramique, la surface de l'aube de turbine possédant une couche d'ancrage et le procédé comprenant le fait de :
retirer de la matière à partir de la surface de la couche d'ancrage à un rythme qui diminue progressivement en utilisant un processus d'abrasion dont l'intensité diminue ;
le procédé d'abrasion comprenant un grenaillage et l'intensité étant réglée en contrôlant la vitesse et/ou la pression du fluide qui contient et qui propulse le milieu abrasif et/ou en réglant la distance de la buse par rapport au substrat.

2. Procédé selon la revendication 1, dans lequel la matière est retirée par abrasion et le procédé en question englobe au moins deux étapes d'abrasion, la première étape retirant de la matière à un rythme au moins deux fois supérieur au rythme de la dernière étape d'abrasion,

3. Procédé selon la revendication 2, qui englobe au moins trois étapes d'abrasion dont l'intensité diminue progressivement.

4. Procédé selon l'une quelconque des revendications précédentes, dans lequel l'abrasion est mise en oeuvre via des particules abrasives de céramique à base d'oxyde.

5. Procédé selon l'une quelconque des revendications précédentes, dans lequel la couche d'ancrage est une couche de MCrAlY.

6. Procédé selon la revendication 5, dans lequel on applique la couche d'ancrage via un procédé choisi parmi le groupe constitué par un dépôt physique en phase vapeur par faisceau d'électrons (EBPVD), un dépôt par arc cathodique, un dépôt par projection au plasma, un dépôt électrolytique et une pulvérisation cathodique.

7. Procédé selon l'une quelconque des revendications précédentes, dans lequel on met en oeuvre un traitement thermique par diffusion avant l'étape opératoire de retrait de matière à un rythme qui diminue progressivement.

8. Procédé selon l'une quelconque des revendications précédentes, dans lequel on met en oeuvre une étape de nettoyage aux ultrasons suite à l'étape opératoire de retrait de matière à un rythme qui diminue progressivement.

9. Procédé selon la revendication 7, dans lequel on met en oeuvre une opération de durcissement par écrouissage superficiel suite à l'étape de traitement thermique par diffusion.

10. Procédé pour appliquer une couche céramique faisant office de barrière thermique sur un substrat métallique, englobant les étapes consistant à :
a) appliquer une couche d'ancrage à base de MCrAlY sur le substrat en utilisant un procédé de dépôt par arc cathodique ;
b) soumettre le substrat enduit à un traitement thermique par diffusion :
c) soumettre à un traitement de durcissement par écrouissage superficiel le substrat enduit qui a fait l'objet d'un traitement thermique par diffusion ;
d) retirer par abrasion de la matière de la couche d'ancrage à un rythme qui diminue progressivement;
e) soumettre à un nettoyage aux ultrasons la couche d'ancrage qui a fait l'objet d'un traitement par invasion ;
f) appliquer un revêtement céramique.

11. Procédé selon la revendication 10, dans lequel le procédé de retrait par abrasion est mis en oeuvre en utilisant des matières abrasives de céramique à base d'oxyde.

12. Procédé selon la revendication 10 ou 11, dans lequel le processus de retrait par abrasion se déroule à un rythme initiai qui est au moins deux fois supérieur au rythme du retrait à la fin du processus de retrait par abrasion.

13. Procédé selon le revendication 10, 11 ou 12, dans lequel le durcissement par écrouissage superficiel est mis en oeuvre jusqu'à une intensité de 13 à 17 N sur l'échelle de Almen.

14. Procédé selon l'une quelconque des revendications 10 à 13, dans lequel le traitement thermique par diffusion est mis en oeuvre à une température d'environ 980 °C (1800 °F) à environ 1150 °C (2100 °F) pendant un laps de temps d'environ 0,5 à environ 10 heures.
